# EUROPÄISCHE PATENTSCHRIFT

(11) **EP 2 759 029 B1**
(45) Veröffentlichungstag und Bekanntmachung des Hinweises auf die Patenterteilung: **22.02.2017**
(21) Anmeldenummer: 11799248.7
(22) Anmeldetag: 23.11.2011
(51) Int. Cl.: H02B 1/20, H02B 1/54, H02B 5/00, H02G 5/02

(54) **HOCHSPANNUNGSANLAGE MIT SOLLBRUCHSTELLE**
HIGH-VOLTAGE SYSTEM WITH PREDETERMINED BREAKING POINT
INSTALLATION HAUTE TENSION DOTÉE D'UN POINT DE RUPTURE

(43) Veröffentlichungstag der Anmeldung: 30.07.2014
(73) Patentinhaber: Siemens Aktiengesellschaft, 80333 München (DE)
(72) Erfinder: ARMSCHAT, Christoph, 91058 Erlangen (DE); BECK, Christoph, 12047 Berlin (DE)
(86) Internationale Anmeldenummer: PCT/EP2011/070818
(87) Internationale Veröffentlichungsnummer: WO 2013/075741

(56) Entgegenhaltungen:
- DE-A1- 3 300 279
- DE-C- 890 083
- US-A- 3 023 990
- US-A- 4 281 213

## Beschreibung

Die Erfindung betrifft eine Hochspannungsanlage zur Energieübertragung mit einer Sammelschiene und wenigstens einem Hochspannungsgerät, das oder die über elektrisch leitende Verbindungsmittel mit der Sammelschiene verbunden sind.

Eine solche Hochspannungsanlage ist beispielsweise aus der DE 890 083 C bekannt. Dort sind Trennschalter einer Hochspannungsanlage über spezielle Träger mit einem Sammelschienensystem verbunden.

Im Bereich der Hochspannungstechnik ist es üblich Anforderungen an die Erdbebensicherheit, durch eine möglichst hohe mechanische Belastbarkeit gerecht zu werden, so dass Kräfte bis zu einem bestimmten Grenzwert sicher aufgenommen werden können. Mechanische Brüche oder umfallende Hochspannungsgeräte sind auf diese Weise vermieden.

Die Erhöhung der Bruch- und Standfestigkeit ist jedoch in der Regel mit einer Erhöhung der Dicke des eingesetzten Materials gekoppelt. Dies führt jedoch zu schweren raumgreifenden Anlagen und hohen Herstellungskosten. Darüber hinaus ist bei unvorhergesehenen Ereignissen, beispielsweise bei einem ungewohnt starken Erdbeben, nicht auszuschließen, dass die vorgegebenen Grenzwerte der mechanischen Belastbarkeit überstiegen werden und es trotz aller Sicherheitsmaßnahmen zu einem Bruch und somit zu einem Ausfall der gesamten Hochspannungsanlage kommt.

Aufgabe der Erfindung ist es daher, eine Hochspannungsanlage der eingangs genannten Art bereitzustellen, die materialsparend, kostengünstig und gleichzeitig sicher ist.

Die Erfindung, wie in den Ansprüchen dargestellt, löst diese Aufgabe dadurch, dass die Verbindungsmittel eine Sollbruchstelle aufweisen, die so ausgelegt ist, dass bei einer vorbestimmten Krafteinwirkung zwischen Sammelschiene und Hochspannungsgerät ein Bruch der Sollbruchstelle erfolgt.

Die Erfindung beruht auf der Idee, eine Hochspannungsanlage in Verbindungselementen nicht mehr mit einer überdimensionierten Materialstärke mit hohen Sicherheitsfaktoren bereitzustellen. Betriebliche Sonderfälle wie z.B. extreme Windlasten oder Kurzschlüsse mit hohen Stromkräften in den hauptstromführenden Leitern entwickeln nur in bestimmten räumlichen Anordnungen und bei großen Stützabständen die Maximalkräfte. In DC Schaltfeldern können Kurzschlusskräfte sogar praktisch vollständig ausgeschlossen werden.

Im Rahmen der Erfindung werden Brüche oder Materialschädigungen von Verbindungselementen zwischen Hochspannungsgeräten nicht mehr vollständig ausgeschlossen. Wesentlich ist im Rahmen der Erfindung jedoch, dass z.B. im Falle eines Erdbebens und bei Überlastung und Sturz eines aufrecht stehenden Hochspannungsgeräts kein Domino-Effekt in dem Sinne erzeugt wird, dass die mit dem umfallenden Hochspannungsgerät über die Sammelschiene verbundenen restlichen Hochspannungsgeräte ebenfalls beschädigt oder gar umgerissen werden. Dies wird im Rahmen der Erfindung durch Sollbruchstellen vermieden, die in einem oder mehreren Verbindungsmittel ausgebildet sind.

Jede Sollbruchstelle ist so ausgelegt, dass eine genau berechnete mechanische Schwächung des Verbindungsmittels gewährleistet ist, die die im Betrieb der Anlage auftretenden Kräfte sicher beherrscht. Durch diese mechanische Schwächung kommt es an der Sollbruchstelle des zugeordneten Verbindungsmittels bei einer die gesetzten Grenzwerte übersteigenden mechanischen Belastung zu einem mechanischen Bruch des Verbindungsmittels. Das beschädigte Hochspannungsgerät wird so elektrisch und mechanisch von der Sammelschiene getrennt. Ein Schaden, der beispielsweise durch Erdbeben entsteht, kann auf diese Weise begrenzt werden. Durch den Bruch des Verbindungsmittels kann das Hochspannungsgerät stürzen, ohne dass die gesamte Hochspannungsanlage mitgerissen wird.

Die Hochspannungsanlage ist vorteilhafterweise eine luftisolierte Hochspannungsanlage.

Im Rahmen der Erfindung ist es besonders zweckmäßig, wenn Hochspannungsgeräte, die eine Bauhöhe von 4 Metern überschreiten, über ein Verbindungsmittel, das eine Sollbruchstelle aufweist, mit der Sammelschiene verbunden sind.

Zweckmäßigerweise ist die Sollbruchstelle durch eine Materialschwächung in den Verbindungsmitteln realisiert. Eine Materialschwächung ist beispielsweise ein Einschnitt oder eine Ausnehmung in dem Verbindungsmittel. Die Verbindungsmittel dienen jedoch auch immer zur elektrischen Verbindung zwischen Hochspannungsgerät und Sammelschiene. Mit anderen Worten bilden sie einen Teil des Strompfads zwischen Hochspannungsgerät und Sammelschiene aus. Durch die Materialschwächung ist der Querschnitt des Strompfades in diesem Teil des Leiterabschnitts verengt. Gleichzeitig ist jedoch die Festigkeit des Verbindungsmittels herabgesetzt. Kommt es zu einer impulsartigen Krafteinwirkung, die einen zuvor festgelegten Schwellenwert überschreitet, bricht das Verbindungsmittel auf und trennt Komponenten zwischen denen die Kräfte wirken. Zweckmäßigerweise trennt es beispielsweise ein umstürzendes Hochspannungsgerät, beispielsweise in Folge eines Erdbebens, von einer Sammelschiene, an der weitere Hochspannungsgeräte angeschlossen sind.

Gemäß einer diesbezüglich zweckmäßigen Weiterentwicklung führt die Materialschwächung eine Querschnittsverengung des Strompfades herbei, die sich über eine Weglänge von weniger als 10mm hinweg erstreckt. Gemäß dieser zweckmäßigen Ausgestaltung der Erfindung ist dafür gesorgt, dass die Zusatzerwärmung durch ohmsche Energieverluste in Zonen verminderter Querschnitte vernachlässigbar klein sind. Darüber hinaus stellen die angrenzenden Bereiche des Verbindungsmittels eine ausreichende Kühlung bereit.

Zweckmäßigerweise weist die Sammelschiene wenigstens einen flexiblen Leiter und/oder einen starren Leiter auf. Sowohl der flexible als auch der starre Leiter, der beispielsweise ein Leitungsrohr ist, können luftisoliert oder gasisoliert sein. Zumindest einige Hochspannungsgeräte sind entweder mit dem flexiblen Leiter oder aber mit dem starren, nicht flexiblen Leiter über die Verbindungsmittel verbunden. Der flexible Leiter ist beispielsweise ein Leitungsseil.

Erfindungsgemäß umfassen die Verbindungsmittel wenigstens eine Klemmeinheit, die einen Flanschabschnitt zum Verbinden mit dem Hochspannungsgerät und einen Klemmabschnitt zum Verbinden mit der Sammelschiene aufweisen, wobei die Sollbruchstelle im Zuge der Kraftübertragung zwischen Flanschabschnitt und Klemmabschnitt angeordnet ist. Abweichend hiervon umfassen die Verbindungsmittel eine Armatur mit jeweils zwei Flanschabschnitten oder eine Klemmeinheit mit zwei Klemmabschnitten.

Gemäß einer diesbezüglichen Weiterentwicklung ist wenigstens eine der Klemmeinheiten mehrteilig ausgebildet und der Flanschabschnitt über ein Klemmverbindungsmittel mit dem Klemmabschnitt verbunden, wobei die Sollbruchstelle an dem Klemmverbindungsmittel ausgebildet ist. Als Klemmverbindungsmittel kommt beispielsweise eine Schraubverbindung in Betracht, die eine Schraube mit Außengewinde aufweist, die in ein in dem Klemmabschnitt ausgebildetes Innengewinde eingreift. Die Sollbruchstelle ist als Materialaussparung in der Schraube vorgesehen. Anstelle einer Schraubverbindung können aber alle sonstigen geeigneten Klemmverbindungsmittel in Betracht kommen, wobei in dem Klemmverbindungsmittel die Sollbruchstelle in Gestalt einer Materialaussparung vorgesehen ist.

Darüber hinaus ist es möglich, wenigstens eine Klemmeinheit einstückig auszubilden, wobei der Flanschabschnitt über einen Verbindungsabschnitt an einen Klemmabschnitt angeformt ist und die Sollbruchstelle in dem Verbindungsabschnitt ausgebildet ist. Bei einer solchen einstückigen Klemmeinheit kann der Verbindungsabschnitt beispielsweise nachträglich eingeschnitten werden, so dass Schlitze in dem Verbindungsabschnitt ausgebildet sind.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: ein Ausführungsbeispiel der Hochspannungsanlage in einer Seitenansicht,
- Figur 2: ein Ausführungsbeispiel einer Klemmeinheit in einer teilweise geschnittenen Vorderansicht,
- Figur 3: die in Figur 2 gezeigte Klemmeinheit in einer Seitenansicht,
- Figur 4: ein weiteres Ausführungsbeispiel einer Klemmeinheit in einer Vorderansicht und
- Figur 5: die Klemmeinheit gemäß Figur 4 in einer Seitenansicht zeigen.

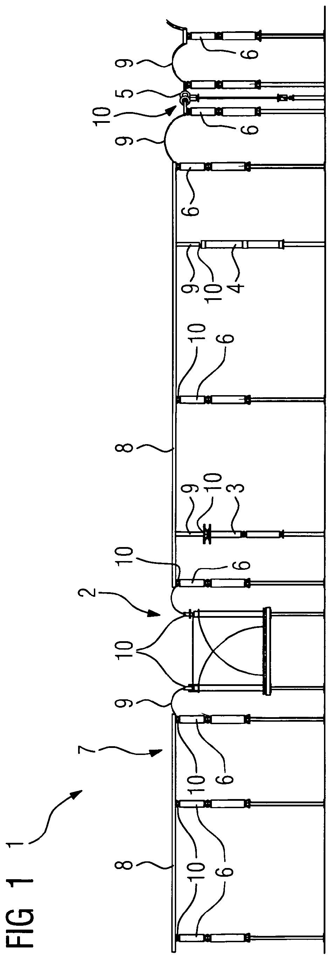

Figur 1zeigt ein Ausführungsbeispiel der erfindungsgemäßen Hochspannungsanlage 1, die einen Trenner oder Trennschalter 2, einen Ableiter 3, einen Kondensator 4, einen ohmschen Widerstand 5 sowie eine Reihe von Stützisolatoren 6 als Hochspannungsgeräte aufweist. Die besagten Hochspannungsgeräte 2, 3, 4, 5 und 6 sind über eine Sammelschiene 7 elektrisch und mechanisch miteinander verbunden, wobei die Sammelschiene 7 einen Rohrleiter 8 als festen Leiter sowie einen flexiblen Leiter 9 umfasst. Sowohl der Rohrleiter 8 als auch der flexible Leiter 9 sind hier luftisoliert. Zur elektrischen und mechanischen Verbindung der Hochspannungsgeräte 2, 3, 4, 5 und 6 mit der Sammelschienen 7 dienen Verbindungsmittel 10, die eine Sollbruchstelle aufweisen. Auf die Ausgestaltung der Verbindungsmittel 10 wird später noch genauer eingegangen. Im Falle eines Erdbebens kann es insbesondere bei hoch, beispielsweise über 2 Meter, aufragenden Hochspannungsgeräten, wie beispielsweise dem Ableiter 3, zum Bruch des äußeren Keramik-Hohlkörperisolators oder des Verbundisolators mit glasfaserverstärktem Kunststoffrohr und somit zum Umsturz kommen. Durch die flexible Anbindung des Ableiters 3 legt dieser zunächst eine freie Fallstrecke zurück bevor es zur Straffung des flexiblen Leiters 9 und einer Krafteinleitung (möglicherweise impulsartigen Krafteinleitung) in das Verbindungsmittel kommt. Aufgrund dieser Krafteinwirkung wird der Bruch des Verbindungsmittels herbeigeführt, wobei der Ableiter 3 von der Sammelschiene 9 getrennt wird. Der Sturz des Ableiters 3 wirkt sich somit nicht auf die restlichen Hochspannungsgeräte 2, 4, 5 und 6 aus.

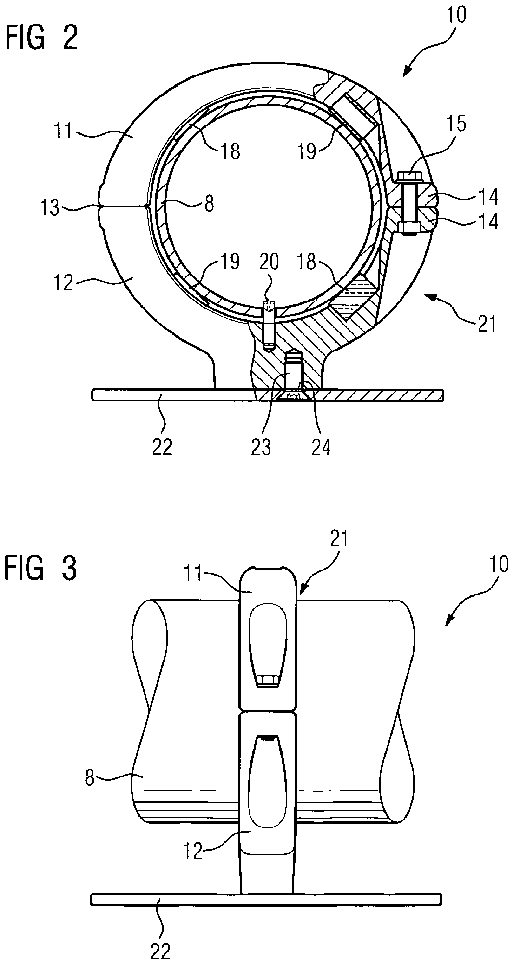

Figur 2 zeigt ein Ausführungsbeispiel einer Klemmeinheit 10 als Teil der Verbindungsmittel einer Hochspannungsanlage 1 gemäß Figur 1. Die Klemmeinheit 10 verfügt über zwei Halbschalen 11 und 12, die an einer Verbindungsstelle 13 aneinander angelenkt sind. An der der Verbindungsstelle 13 gegenüber liegenden Seite der Klemmeinheit 10 bilden die Halbschalen 11 und 12 jeweils einen Flanschabschnitt 14 aus, wobei die beiden Flanschabschnitte 14 mittels einer Schraubverbindung 15 miteinander fest verbunden sind. In dem gezeigten geschlossenen, nicht aufgeschwenkten Zustand der Halbschalen 11 und 12 begrenzen diese einen kreisförmigen Innenbereich, dessen Innendurchmesser dem Außendurchmesser des aufzunehmenden Rohrleiters 8 der Sammelschiene 7 entspricht. Die Halbschalen 11 und 12 sind aus einem elektrisch leitfähigen Material, beispielsweise Kupfer oder Aluminium, gefertigt. Zur Aufnahme des Rohrleiters 8 und seiner mechanisch gedämpften Lagerung dienen Kunststofflager 18 sowie Dämpfungselemente 19, die in den Halbschalen 11 und 12 angeordnet sind, wobei sie dem Rohrleiter 8 zugewandt sind. Darüber hinaus ist die Halbschale 12 mit einer Stiftverbindung 20 ausgerüstet, die sich durch eine Durchgangsöffnung des Rohrleiters 8 hindurch erstreckt. Auf diese Weise ist für eine mechanische Anbindung des Rohrleiters 8 an die Klemmeinheit 10 und umgekehrt gesorgt.

Die Klemmeinheit 10 verfügt neben dem durch die Halbschalen 11 und 12 gebildeten Klemmabschnitt 21 über einen Flanschabschnitt 22, mit dem die Klemmeinheit 10 fest mit dem Stützisolator 6 verbunden ist. Der Flanschabschnitt 22 ist in dem in Figur 2 gezeigten Ausführungsbeispiel in einer nicht gezeigten Draufsicht kreisförmig ausgestaltet und weist Durchgangsbohrungen auf, die kranzförmig im Außenbereich des Flanschabschnitts 22 angeordnet sind. Mit Hilfe dieser Durchgangsöffnungen kann die Klemmeinheit 10 fest beispielsweise mit dem Stützisolator 6 gemäß Figur 1 verschraubt werden. Zur Verbindung zwischen Flanschabschnitt 22 und Klemmabschnitt 21 dient in dem gezeigten Ausführungsbeispiel eine Schraube 23 als Klemmverbindungsmittel, die einen kleinen seitlichen Einschnitt 24 als Sollbruchstelle aufweist. Dieser Einschnitt 24 hat natürlich eine Materialschwächung im Gefolge, so dass die mechanische Festigkeit der Schraube in diesem Bereich herabgesetzt ist. Bei eingeleiteten Kräften, die einen vorbestimmten Grenzwert überschreiten, kommt es zum Bruch der Schraube und somit zu einer Trennung der mechanischen Verbindung zwischen Stützisolator 6 sowie der Sammelschiene 7. Werden die Kräfte außerdem noch pulsartig eingeleitet so bietet die träge Masse des Geräts einen weiteren Schutz noch über die statische Biegebelastbarkeit des Geräts hinaus.

Figur 3 zeigt die Klemmeinheit 10 gemäß Figur 2 in einer Seitenansicht. Insbesondere ist die Rohrleiter 8 gut erkennbar.

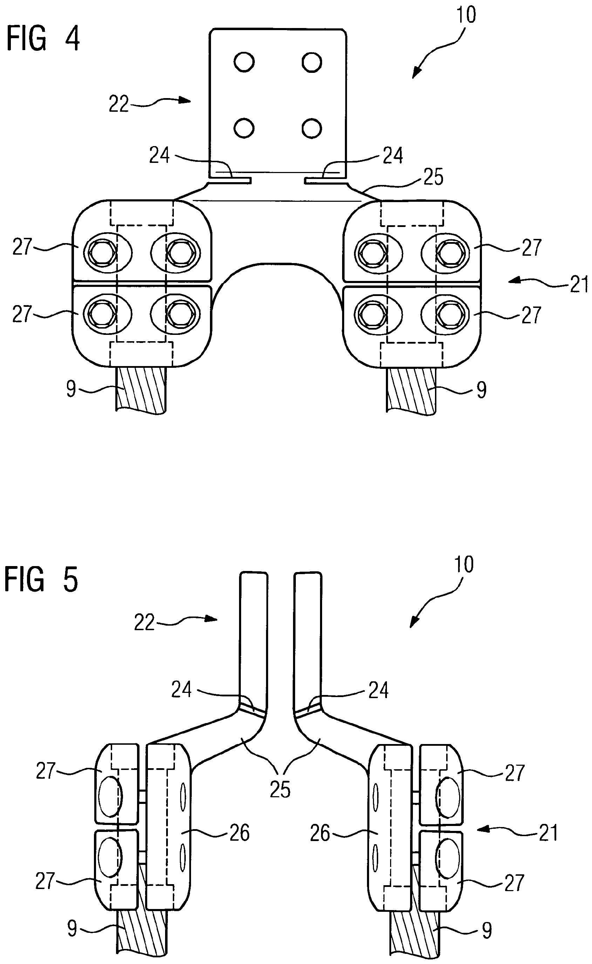

Figur 4 zeigt ein weiteres Ausführungsbeispiel einer einstückigen Klemmeinheit 10, die ebenfalls wieder einen Flanschabschnitt 22 zur festen Verbindung mit einem Hochspannungsgerät sowie einen Klemmabschnitt 21 aufweist, der wiederum zum mechanischen und elektrischen Verbinden mit einem flexiblen Leiter 9 der Sammelschiene 7 dient. Zwischen dem Klemmabschnitt 21 und dem Flanschabschnitt 22 erstreckt sich ein Verbindungsabschnitt 25, in dem Einkerbungen 24 erkennbar sind. Durch die Einkerbungen 24 ist eine Querschnittsverengung der durch den Verbindungsabschnitt 25 ausgebildete Leiterbahn hervorgerufen, wodurch es zu einer Wärmeentwicklung während des Betriebs der Hochspannungsanlage 1 kommen kann. Während des Betriebs fließt ein von der Hochspannung getriebener Strom zwischen dem Flanschabschnitt 22 und dem Klemmabschnitt 21, wobei der Strompfad über den Verbindungsabschnitt 25 führt. Die Querschnittsfläche dieses Strompfads entspricht der Fläche, die in der quer geschnittenen Ansicht von der Kontur des Verbindungsabschnittes 25 umschlossen ist. Diese Leiterfläche wird durch die Einschnitte 24 verengt mit einer geringfügig erhöhten Wärmeentwicklung im Gefolge. Durch diese Materialschwächung 24 ist jedoch eine mechanische Schwächung des Klemmabschnitts 10 und somit eine Sollbruchstelle bereitgestellt. Da die Materialschwächung sich entlang des Strompfads nur über Millimeter bis wenige Zentimeter erstreckt, ist die entstehende Wärmeentwicklung moderat.

Die Ausgestaltung des Flanschabschnitts 22 ist dem Fachmann bekannt (Hochspannungs-Anschlussklemme), so dass hier nicht genauer darauf eingegangen zu werden braucht. Es sei nur erwähnt, dass der Flanschabschnitt 22 eine Anschlussfahne ausbildet, die vier Durchgangsbohrungen aufweist. Die Durchgangsbohrungen dienen zum Verschrauben der Klemmeinheit 10 mit dem jeweiligen Hochspannungsgerät.

In Figur 5 ist erkennbar, dass der Klemmabschnitt 21 einen mit dem Verbindungsabschnitt 25 fest verbundenen Widerlagerbereich 26 aufweist, auf den zwei Halbschalen 27 aufschraubbar sind. Zwischen den Halbschalen 27 und dem Widerlagerbereich 26 ist das freie Ende des flexiblen Leiters 9 angeordnet. Durch Verschrauben wird der Abstand zwischen den Widerlagern 27 und dem Widerlagerbereich 26 verringert, wodurch eine Klemmkraft und Haltewirkung zum Halten des flexiblen Leiters 9 bereitgestellt ist.

## Patentansprüche

1. Hochspannungsanlage (1) zur Energieübertragung mit einer Sammelschiene (7) und wenigstens einem Hochspannungsgerät (2,3,4,5,6), das oder die über elektrisch leitende Verbindungsmittel (10) mit der Sammelschiene (7) verbunden sind, **dadurch gekennzeichnet, dass** die Verbindungsmittel (10) eine Sollbruchstelle (24) aufweisen, die so ausgelegt ist, dass bei einer vorbestimmten Krafteinwirkung zwischen Sammelschiene (7) und Hochspannungsgerät (2,3,4,5,6) ein Bruch der Sollbruchstelle (24) erfolgt, wobei die Verbindungsmittel wenigstens eine Klemmeinheit (10) umfassen, die einen Flanschabschnitt (22) zum Verbinden mit dem Hochspannungsgerät (2,3,4,5,6) und einen Klemmabschnitt (21) zum Verbinden mit der Sammelschiene (7) aufweist, wobei die Sollbruchstelle (24) im Zuge der Kraftübertragung zwischen Flanschabschnitt (22) und Klemmabschnitt (21) angeordnet ist.

2. Hochspannungsanlage (1) nach Anspruch 1,
**dadurch gekennzeichnet, dass** die Sollbruchstelle (24) durch eine Materialschwächung in den Verbindungsmitteln (10) realisiert ist.

3. Hochspannungsanlage (1) nach Anspruch 2,
**dadurch gekennzeichnet, dass** die Materialschwächung (24) eine Querschnittsverengung des Strompfades herbeiführt, die sich über eine Weglänge von weniger als 10mm hinweg erstreckt.

4. Hochspannungsanlage (1) nach einem der vorhergehenden Ansprüche,
**dadurch gekennzeichnet, dass** die Sammelschiene (7) wenigstens einen flexiblen Leiter (9) und/oder einen starren Leiter (8) aufweist.

5. Hochspannungsanlage (1) nach einem der vorangehenden Ansprüche,
**dadurch gekennzeichnet, dass** eine Klemmeinheit (10) mehrteilig ausgebildet ist und der Flanschabschnitt (22) über ein Klemmverbindungsmittel (23) mit dem Klemmabschnitt (21) verbunden ist, wobei die Sollbruchstelle (24) an dem Klemmverbindungsmittel (23) ausgebildet ist.

6. Hochspannungsanlage (1) nach einem der vorangehenden Ansprüche 1 bis 4,
**dadurch gekennzeichnet, dass** eine Klemmeinheit (10) einstückig ausgebildet ist, wobei der Flanschabschnitt (22) über einen Verbindungsabschnitt (25) an den Klemmabschnitt (21) angeformt ist und die Sollbruchstelle (24) in dem Verbindungsabschnitt (25) ausgebildet ist.

## Claims

1. High-voltage installation (1) for energy transmission comprising a busbar (7) and at least one high-voltage device (2, 3, 4, 5, 6), which device or devices is/are connected to the busbar (7) via electrically conductive connecting means (10),
**characterized in that**
the connecting means (10) have a desired breaking point (24) which is designed in such a way that, in the event of a predetermined force effect between the busbar (7) and the high-voltage device (2, 3, 4, 5, 6), breaking of the desired breaking point (24) takes place, wherein the connecting means comprise at least one clamping unit (10), which clamping unit has a flange section (22) for connection to the high-voltage device (2, 3, 4, 5, 6) and a clamping section (21) for connection to the busbar (7), wherein the desired breaking point (2) is arranged between the flange section (22) and the clamping section (21) over the course of the force transfer.

2. High-voltage installation (1) according to Claim 1,
**characterized in that**
the desired breaking point (24) is realized by a portion of weakened material in the connecting means (10).

3. High-voltage installation (1) according to Claim 2,
**characterized in that**
the portion of weakened material (24) brings about a cross-sectional constriction of the current path which extends beyond a path length of less than 10 mm.

4. High-voltage installation (1) according to one of the preceding claims,
**characterized in that**
the busbar (7) has at least one flexible conductor (9) and/or one rigid conductor (8).

5. High-voltage installation (1) according to one of the preceding claims,
**characterized in that**
a clamping unit (10) has a multipart design and the flange section (22) is connected to the clamping section (21) via a clamping connecting means (23), wherein the desired breaking point (24) is formed on the clamping connecting means (23).

6. High-voltage installation (1) according to one of the preceding Claims 1 to 4,
**characterized in that**
a clamping unit (10) is formed integrally, wherein the flange section (22) is integrally formed on the clamping section (21) via a connecting section (25) and the desired breaking point (24) is formed in the connecting section (25).

## Revendications

1. Installation ( 1 ) de haute tension pour transporter de l'énergie, comprenant une barre ( 7 ) collectrice et au moins un appareil ( 2, 3, 4, 5, 6 ) de haute tension, qui est relié à la barre ( 7 ) collectrice par des moyens ( 10 ) de liaison conducteurs de l'électricité,
**caractérisé en ce que**
les moyens ( 10 ) de liaison ont un point ( 24 ) destiné à se rompre, conçu de manière à ce que, si une force définie à l'avance est appliquée entre la barre ( 7 ) collectrice et l'appareil ( 2, 3, 4, 5, 6 ) de haute tension, il se produit une rupture du point ( 24 ) destiné à se rompre, les moyens de liaison comprenant au moins une unité ( 10 ) de serrage, qui a une partie ( 22 ) de bride pour la liaison à l'appareil ( 2, 3, 4, 5, 6 ) de haute tension et une partie ( 21 ) de serrage pour la liaison à la barre ( 7 ) collectrice, le point ( 24 ) destiné à se rompre au cours de l'application d'une force étant disposé entre la partie ( 22) de bride et la partie ( 21 ) de serrage.

2. Installation ( 1 ) de haute tension suivant la revendication 1,
**caractérisée en ce que**
le point ( 24 ) destiné à se rompre est réalisé par un affaiblissement du matériau des moyens ( 10 ) de liaison.

3. Installation ( 1 ) de haute tension suivant la revendication 2,
**caractérisée en ce que** l'affaiblissement ( 24 ) du matériau provoque un rétrécissement de la section transversale du trajet du courant, qui s'étend sur une longueur de trajet de moins de 10 mm.

4. Installation ( 1 ) de haute tension suivant l'une des revendications précédentes,
**caractérisée en ce que** la barre ( 7 ) collectrice a au moins un conducteur ( 9 ) souple et/ou un conducteur ( 8 ) rigide.

5. Installation ( 1 ) de haute tension suivant l'une des revendications précédentes,
**caractérisée en ce qu'**une unité ( 10 ) de serrage est constituée en plusieurs parties et la partie ( 22 ) de bride est reliée à la partie ( 21 ) de serrage par un moyen ( 23 ) de liaison de serrage, le point ( 24 ) destiné à se rompre étant formé sur le moyen ( 23 ) de liaison de serrage.

6. Installation ( 1 ) de haute tension suivant l'une des revendications précédentes 1 à 4,
**caractérisée en ce que**
une unité ( 10 ) de serrage est constituée d'une seule pièce, la partie ( 22 ) de bride étant formée sur la partie ( 21 ) de serrage par une partie ( 25 ) de liaison et le point ( 24 ) destiné à se rompre étant formé dans la partie ( 25 ) de liaison.
